Europäisches Patentamt

European Patent Office

Office européen des brevets

(19)

(11) Publication number: **0 180 677**

**A1**

(12) # EUROPEAN PATENT APPLICATION

(21) Application number: **84402031.3**

(22) Date of filing: **10.10.84**

(51) Int. Cl.⁴: **H 03 M 1/06**

(43) Date of publication of application:
**14.05.86 Bulletin 86/20**

(84) Designated Contracting States:
**DE FR GB IT NL**

(71) Applicant: **FAIRCHILD CAMERA & INSTRUMENT CORPORATION**
**464 Ellis Street**
**Mountain View California 94042(US)**

(72) Inventor: **Sloane, Edwin A.**
**1040 Covington Road**
**Los Altos California 94022(US)**

(74) Representative: **Chareyron, Lucien et al,**
**Schlumberger Limited Service Brevets c/o Giers 12, place des Etats Unis B.P. 121**
**F-92124 Montrouge Cédex(FR)**

(54) **Apparatus for compensating analog to digital converter errors.**

(57) A high precision analog to digital converter comprises the combination of an imperfect or low resolution digital to analog converter having an error function known in terms of orthonormal components and an error compensating device capable of generating correction terms which do not interact with one another. The correction terms are based on orthonormal components namely, the Walsh function components, of each signal level to be compensated. At most only one weighting value per bit is required, the combination of which will compensate for errors of any bit combination. In a specific embodiment employing feedback compensation, the output of the low resolution converter and of the compensating device may be summed to produce a high performance, high precision converter with increased accuracy and resolution.

FIG._5.

EP 0 180 677 A1

APPARATUS FOR COMPENSATING
ANALOG TO DIGITAL CONVERTER ERRORS

## Background of the Invention

### 1. Field of the Invention

This invention relates to digital electronic converters and particularly to methods and apparatus for converting analog signals into digital signals.

Converters between digital and analog domains are employed to interface between digital electronic circuitry and devices requiring analog signals. Accuracy of conversion, gain and repeatability in the process of conversion are matters of concern which are important to evaluate and for which compensation is frequently required.

Precision converters are needed for critical conversion applications. However, precision converters are generally expensive and difficult to implement. Reasonable cost, commercial quality converters frequently suffer from errors in conversion which render them unusalbe for critical applications. What is needed is a technique for increasing the accuracy of reasonably reliable commercially available converters so they can be used even in critical applications.

2.    Description of the Prior Art

        Trimming techniques for analog to digital and
digital to analog converters have been suggested for
limited purposes.  For example, L.F. Pau, "Fast Testing
and Trimming of A/D and D/A Converters in Automatic Test
Systems", 1978, IEE Auto Test Conference, has suggested a
method for trimming converters based on the use of Walsh
functions.  A more generalized proposal for correction of
converter errors based on Walsh functions is described in
J.T. Millman, "Error Minimization of Data-Converting
Systems via Generalized Spectral Analysis," Ph.D. Thesis,
Massachusetts Institute of Technology, submitted August
21, 1975 (available October 27, 1985).  Specifically,
Millman suggests the use of on-the-converter
error-correction circuitry employing Walsh functions which
can be generated through the use of  of EXCLUSIVE OR
functions under control of a programmable read only
memory.  Millman suggests incorporation of correction
circuitry into the original design and layout of a digital
to analog converter and specifically the provision of fine
control of the current-setting resistor internal to the
digital to analog converter.  However, Millman recognized
the infeasibility of implementing on-the-converter
correction circuitry for any interactive Walsh function
errors in existing circuitry.  Millman's work has been
limited to internal compensation and has made no
suggestion for alternative solutions.
        Intersil, Inc. of Cupertino, California
manufactures a correcting digital to analog converter
device under the trade name ICL 7134.  The ICL 7134 is a
multiplying digital to analog converter which has a
programmable read only memory array for controlling a 12
bit correcting digital to analog converter in the same device. The structure allows for modulo-32 cyclical corrections to be applied to the signal output. However, with the Intersil device, it is very difficult to correct for non-linearitites in the analog output because all digital input functions are inter-related. Furthermore, only a group of the most significant bits are used for error correction so that significant errors involving the lower significant bits are potentially ignored.

It is a general object of the present invention to provide an improved apparatus for converting an analog input signal into a digital output signal.

This and other objects are attained, in accordance with one aspect of the invention, by an apparatus for converting an analog input signal to a digital output signal comprising an analog to digital converter device having a known digital signal conversion error for producing a digital signal in response to an analog signal; means coupled to said digital to analog converter device for producing a compensating signal, specific to said conversion error and non-interacting with said input signal; and means for adjusting said digital output signal in accordance with said conversion error for producing a corrected digital output signal.

Another aspect includes an apparatus for converting an analog input signal to digital output signal comprising a digital to analog converter device responsive to said digital output signal having an analog signal conversion error for producing an analog feedback signal, said conversion error being known in terms of orthonormal components of the input signal; an analog signal error compensating device responsive to said digital output signal for producing an analog compensating signal specific to said conversion error and non-interacting with said digital to analog converter; and means for summing said analog feedback signal and said analog compensating signal to produce said analog input signal for conversion to said digital output signal.

The invention will be better understood by reference to the following detailed description taken in connection with the accompanying drawings.

## Brief Description of the Drawings

FIG. 1 is a block diagram of a device according to the invention wherein feedback correction is employed.

FIG. 2 is a block diagram of the invention wherein serial post-correction is employed..

FIG. 3 is a block diagram of the invention wherein serial pre-correction is employed.

FIG. 4 is a block diagram of the invention wherein feedforward correction is employed.

FIG. 5 is a block diagram of a specific embodiment of a feedback correction network according to the invention.

## Description of Specific Embodiments

It is known that Walsh functions are well suited to the representation of memoryless transfer characteristics of mixed signal devices such as digital to analog converters and analog to digital converters employing digital to analog converters internally. This is because the Walsh functions form a complete set of orthogonal two- state functions capable of representing any reasonable function spanning a multiple of a binary number of intervals. As a consequence, all compensating functions based on the orthogonal binary functions are independent of one another and hence do not interact in any potential adjustment or correction scheme. However, Walsh functions are but one example of an orthonormal set of digital functions upon which correction signals may be based. Reference is made to E.P.O. Patent Appln. No. 81.401721.6 for a discussion of such functions.

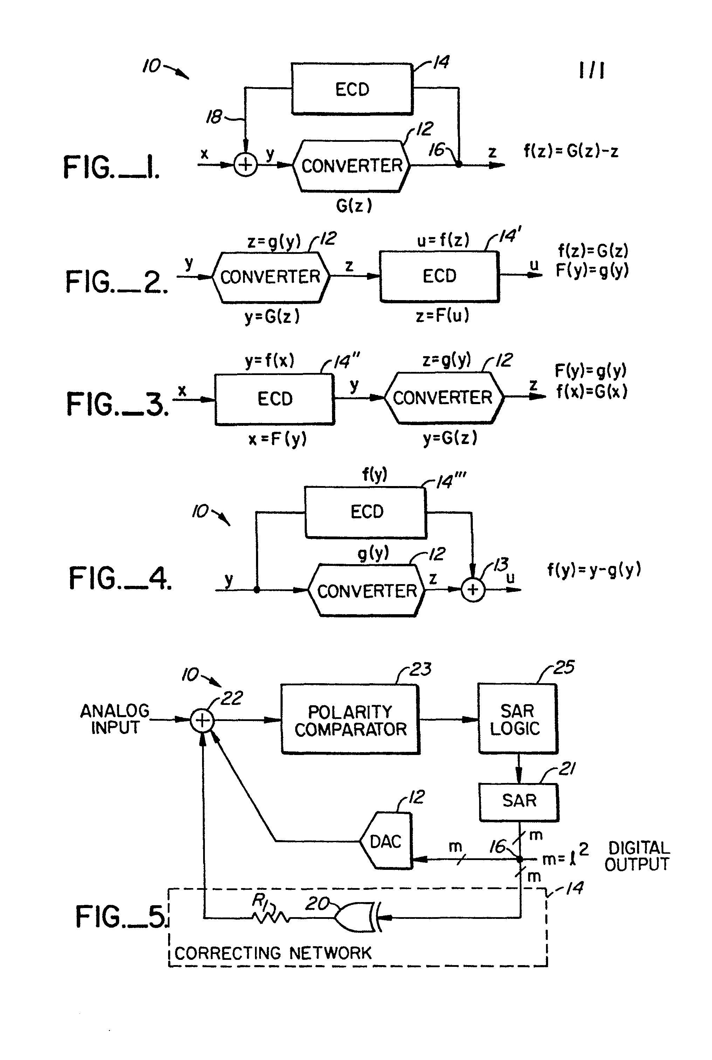

Referring to FIG. 1, there is shown one embodiment of a converter system 10 according to the invention comprising an analog to digital converter 12 having a known error characteristic or error function and a compensating device 14. The compensating device 14 responds to the digital output at an output node 16 of the converter 12 and produces an analog output on an analog signal line 18 as an analog compensating signal. The function of the converter 12 may be expressed as g(y) which produces an analog signal z in response to a digital input signal y. The error compensating device 14 may be expressed as a function f(z). The forward function f(z) is specifically tailored to produce a value equal to the value G(z)-z expressed in analog terms at its output where G(z) is the reverse function of the converter 12. The sum of the analog correction signal on line 18 and the analog input signal x is a value y which is the desired input signal in analog form to the converter 12. The y valued signal in a properly designed system 10 is a properly scaled analog signal to produce a properly scaled digital output signal z corresponding to the analog input signal x.

Referring to FIG. 2, there is shown another possible configuration for an apparatus according to the invention.

In this embodiment a signal z is applied to an error compensating device 14' which produces an output signal u which is a function f(z). A converter 12 having a function g(y) produces the digital output signal z to be corrected. This scheme is called serial post-correction. In this embodiment the error correcting device may contain a digital look-up device.

FIG. 3 illustrates serial pre-correction wherein an error compensating device 14" applies an analog output signal y to the converter 12. In this case, the forward function of the error compensating device 14" f(x) is equal to the reverse function G(x) of the converter 12, and the reverse function F(y) of the error compensating device 14" is equal to the forward function g(y) of the converter 12.

FIG. 4 illustrates a feedforward technique for correcting converter output. The error compensating device 14''' receives as an analog input the input signal y to the converter 12 and provides a digital output to a digital adder 13. The adder 13 adds a digital signal to the digital output signal z, the sum of which is the desired output signal u of the device 10.

Either the forward transfer characteristic of the converter 12 or the inverse function of the converter 12 must be known in terms of orthonormal components before compensation may be applied. The forward transfer characteristic may be obtained by uniformly varying the input to the device and observing the response to which inverse Walsh domain filtering may be applied. Equivalently, since the source of error in an analog to digital converter may be the internal digital to analog converter, the internal digital to analog converter may be separately analyzed and the inverse function can be obtained by analysis.

The inverse function may be obtained by using a uniformly distributed input function, y, so that:

$$p(y) = \frac{1}{Y}$$

And noting that the density function of the response function is:

$$p(z) = p(y) \frac{dy}{dz} = \frac{1}{Y} G'(z)$$

so that

$$G(z) = Y \int p(z) dz$$

In the case of ADC, G(z) might also be obtained by means of exponential excitation as described in E.P.O. Patent Appln. No. 81.401721.6.

Each of the compensating methods have preferred applicability to either ADC's or DAC's depending on the availability of the digital code. Consider for instance, the following input/output relationship:

$$z = g(y) = g(ny_o) = g(n)$$

Where the input, y, is uniformly quantized with increments of $y_o$. In terms of the Walsh functions:

$$z = \sum_{k=o}^{2^m-1} g_k \cdot \Psi_k(n) \quad , \quad 2^m y_o = 1$$

where

$$g_k = \sum_{n=o}^{N-1} g(n) \cdot \Psi_k(n)$$

The output, z, at any given quantized input state, n, will be the weighted sum of all the significant Walsh terms. The set of weights, $(g_k)$, will be either added or subtracted depending on the sign of the Walsh functions, $\{\Psi_k(n)\}$, at state n. Because the state of the binary order Walsh functions, $\{\Psi_{2^\ell}(n)\}$, is known from the input state n, i.e., the corresponding binary input code indicates the sign of the binary ordered functions, the sign of any other (non-binary) Walsh function may be determined by means of the generating rule. Thus;

$$\Psi_{k\theta\ell}(n) = \Psi_k(n) \cdot \Psi_\ell(n)$$

If $k \neq \ell$ and both are of binary order,

$$\Psi_{k+\ell}(n) = \Psi_k(n) \cdot \Psi_\ell(n)$$

And the sign (signum) of the resultant will be;

$$\text{sgn } \{\Psi_{k+\ell}(n)\} = \text{sgn } \{\Psi_k(n)\} \cdot \text{sgn } \{\Psi_\ell(n)\}$$

In general, the sign will be the product of the appropriate binary ordered Walsh functions which are determined by the binary code of the input state n.

The equivalent logical operation based on the logical (on-off) representation of the Walsh functions is:

$$\overline{\phi}_{k\oplus 1}(n) = \phi_k(n) \oplus \overline{\phi}_\ell(n)$$

Where $\oplus$ represents the EOR operation, and $\overline{\phi}$ is the logical complement of $\phi$. The availability of quantized data is an important consideration in the selection of a correction scheme for an analog to digital converter. A digital to analog converter has quantized inputs. Hence the method of FIG. 1, feedback correction is best suited for applications with an analog to digital converter.

FIG. 5 illustrates a specific embodiment of an analog to digital converter device 10 having feedback correction. In FIG. 5, a converter 12 receiving input from a successive approximation register 21 is fed by m bits of information, m bits of which are applied to the converter 12 and the m bits being applied to an error compensating device 14. Only one representative channel of the error compensating device 14 is shown. In practice, the error compensating device 14 may have as many channels as converter bits, and in general less. The error compensating device 14 comprises a plurality of channels of EXCLUSIVE OR gates 20 each receiving a different set of digital input bit lines of the m input signals. The exact input bit line configuration is defined by the orthogonal components of error function associated with the converter 12. Each EXCLUSIVE OR gate 16 is provided with TRUE input states of one level to be corrected. The weighting of the signal line set is either added or subtracted and the magnitude of the weighting is defined by a resistance of the corresponding EXCLUSIVE OR gate. $R_1$ corresponds to the weight for gate 20. In the specific embodiment, the EXCLUSIVE OR gate 20 is a device having an output suitable for driving the corresponding output resistor R. The output resistor is in turn coupled to a summer 22 with the output of the converter 12. An operational amplifier is a suitable summer. Whenever any one of the EXCLUSIVE OR gate outputs is true, an analog signal is generated representing the corresponding orthogonal component of the input digital signal. The analog signals add at the summing junction. The analog output of the summer 22 is the desired corrected analog signal to be applied to the feedback input of the device 10. The corrected input is then applied to a polarity comparator 23 whose output is applied to the SAR logic subsystem 25 which in turn runs the successive approximation register 21. The digital output is taken from the output node 16.

The invention has now been explained with reference to the specific embodiments. Other embodiments will be apparent to those of ordinary skill in the art. For example, one of the advantages of a correction network as shown herein is that no more than one weighting factor per bit is required, since each weighting factor is determined by an analysis of the orthonormal characteristics of that bit with respect to all other bits. Simple EXCLUSIVE OR logical correcting
networks have been found to require normally only pairs
of input data bits, and generally 0, 1, 2 or 3 combinations of input bits for purposes of correction. Large
complex networks are thus unnecessary, and correction
networks can be incorporated into devices easily
coupled together with ordinary digital to analog
converters. Variable resistors may be used for weighting, the adjustments of which can be made empirically,
based on an error function analysis by orthonormal
components of the converter to be corrected. It is
therefore not intended that this invention be limited
except as indicated by the appended claims.

0180677

CLAIMS:

1. An apparatus for converting an analog input signal to a digital output signal characterized by:

an analog to digital converter device having a known digital signal conversion error for producing a digital signal in response to an analog signal;

means coupled to said digital to analog converter device for producing a compensating signal, specific to said conversion error and non-interacting with said input signal; and

means for adjusting said digital output signal in accordance with said conversion error for producing a corrected digital output signal.

2. The apparatus according to claim 1 characterized in that said error compensating device is operative to decompose a digital signal representation of input signals into a single correcting signal for each combination of bits to be compensated, and means for weighting said correcting signal to produce said compensating signal.

3. The apparatus according to claim 1 or 2 characterized in that said compensating device is operative to generate said compensating signal from Walsh function components of a digital input signal.

4. The apparatus according to claim 3 characterized in that said analog to digital converter device comprises a polarity comparator coupled to receive an input analog signal, a successive approximation register means coupled to receive ouput of said polarity comparator to produce a digital output signal, a digital to analog converter coupled to receive the output of said successive approximation register means to produce an analog feedback signal and summing means coupled to produce said feedback signal and said analog input signal for input to said polarity

**0180677**

comparator, and wherein said error compensating device
comprises at least one EXCLUSIVE OR gate coupled to
receive at least selected ones of said digital output
signals to produce a two-level correcting signal, and
wherein said weighting element comprises a resistor for
converting said correcting signal into a compensating
signal, said compensating signal being coupled in
feedback to said combining means for compensating for
converter errors in said analog to digital converter
device.

5. An apparatus for converting an analog input
signal to digital output signal characterized by:
a digital to analog converter device
responsive to said digital output signal having an
analog signal conversion error for producing an analog
feedback signal, said conversion error being known in
terms of orthonormal components of the input signal;
an analog signal error compensating device
responsive to said digital output signal for producing
an analog compensating signal specific to said
conversion error and non-interacting with said digital
to analog converter; and
means for summing said analog feedback signal
and said analog compensating signal to produce said
analog input signal for conversion to said digital
output signal.

6. The apparatus according to claim 5
characterized in that said error compensating device is
operative to generate an analog error compensating
signal from Walsh function components of said digital
output signal.

7. The apparatus according to claim 5 or 6
characterized in that said signal error compensating
device comprises a plurality of EXCLUSIVE OR gates
operative to combine selected ones of said digital

- 13 -

0180677

output signal values into a plurality of error correcting signals, each error correcting signal corresponding to an orthonormal component of signals produced by said digital to analog converter device to be compensated and a weighting element, said weighting element producing said compensating signal.

8. The apparatus according to claim 6 characterized in that said signal error compensating device comprises a plurality of EXCLUSIVE OR gates operative to combine selected ones of said digital output signal values into a plurality of error correcting signals, each error correcting signal corresponding to an orthonormal component of signals produced by said digital to analog converter device to be compensated, and a weighting element, said weighting element producing said compensating signal.

9. The apparatus according to claim 5 characterized in that said analog signal error compensating device is operative to decompose said digital output signal into orthogonal components and further including an EXCLUSIVE OR means for combining values representing selected ones of said orthogonal components into a single correcting signal for each combination of bits to be compensated, and at least one weighting element, each weighting element coupled to receive one said correcting signals for producing a component of said analog compensating signal.

10. The apparatus according to claim 9 characterized in that each said weighting element is a resistor, said resistor being driven by the output of said corresponding EXCLUSIVE OR gate.

11. The apparatus according to claim 9 characterized in that said weighting element is a digital look-up table having individual outputs defining correction values, said digital look-up table being coupled through a combining network.

1/1

FIG.__1.

$x \xrightarrow{} \oplus \xrightarrow{y}$ CONVERTER $\xrightarrow{z}$ $f(z) = G(z) - z$

G(z)

ECD

$f(z) = G(z) - z$

FIG.__2.

$y \xrightarrow{}$ CONVERTER $z = g(y)$ $\xrightarrow{z}$ ECD $u = f(z)$ $\xrightarrow{u}$

y = G(z)    z = F(u)

$f(z) = G(z)$
$F(y) = g(y)$

FIG.__3.

$x \xrightarrow{}$ ECD $y = f(x)$ $\xrightarrow{y}$ CONVERTER $z = g(y)$ $\xrightarrow{z}$

x = F(y)    y = G(z)

$F(y) = g(y)$
$f(x) = G(x)$

FIG.__4.

ECD f(y)

$y \xrightarrow{}$ CONVERTER $g(y)$ $\xrightarrow{z} \oplus \xrightarrow{u}$

$f(y) = y - g(y)$

FIG.__5.

ANALOG INPUT $\xrightarrow{}$ $\oplus$ $\xrightarrow{}$ POLARITY COMPARATOR $\xrightarrow{}$ SAR LOGIC

SAR

DAC

m $\xrightarrow{}$ m    16    $m = \ell^2$    DIGITAL OUTPUT

$R_1$    20    m

CORRECTING NETWORK

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | IEEE INTERNATIONAL TEST CONFERENCE 1983 PROCEEDINGS, 18th-20th October 1983, paper 2.4, pages 598-605, IEEE, New York, US; E.A. SLOANE et al.: "A general method for increasing converter accuracy and resolution"<br>* Page 598, column 1, line 24 - column 2, line 2; page 599, column 2, line 45 - page 600, column 2, line 21; page 601, column 2, lines 11-31; figures 3-5 *<br>--- | 1-10 | H 03 M  1/06 |
| Y | Idem<br>--- | 11 | |
| X | ELECTRONICS LETTERS, vol. 14, no. 24, 23rd November 1978, pages 790-791, Hitchin, Herts, GB; J.R. STOCKTON et al.: "Some proposals for improved forms of precision fast digital-analogue and analogue-digital convertors"<br>* Page 790, column 2, lines 22-39; page 166, figure 2 *<br>--- | 1 | TECHNICAL FIELDS SEARCHED (Int. Cl.4)<br><br>H 03 M |
| Y | Idem<br>----- | 11 | |

The present search report has been drawn up for all claims

| Place of search | Date of completion of the search | Examiner |
|---|---|---|
| THE HAGUE | 20-06-1985 | BEINDORFF W.H. |